# EUROPEAN PATENT APPLICATION

(11) **EP 4 668 507 A1**
(43) Date of publication of application: **24.12.2025**
(21) Application number: 24756532.8
(22) Date of filing: 15.01.2024
(51) Int. Cl.: H01S 5/24, H01S 5/22

(54) **SEMICONDUCTOR LASER CHIP**

(30) Priority: 15.02.2023 JP 2023022027
(71) Applicant: Fujikura Ltd., Tokyo 135-8512 (JP)
(72) Inventor: KAWAKAMI, Toshiyuki, Sakura-shi, Chiba 285-8550 (JP)
(74) Representative: Plasseraud IP
(86) International application number: PCT/JP2024/000804
(87) International publication number: WO 2024/171681

(57) **Abstract**

Provided is a semiconductor laser chip in which a failure is less likely to occur even when a drive time is long. A broad area type semiconductor laser chip (chip 10) includes a substrate (11), an active layer (13), and a current injection stripe which injects a current into the active layer (13). A pair of side surfaces of the chip include respective rough surfaces (1142, 1162), which serve as starting points of cleavage, and respective cleavage surfaces (1141, 1161), grooves (G1, G2) penetrating the active layer (13) are each formed in a region between a corresponding one of the rough surfaces (1142, 1162) and the current injection stripe, and spacing between each of the grooves (G1, G2) and the corresponding one of the side surfaces is not less than 25 pm.

## Description

### Technical Field

The present invention relates to a broad area type semiconductor laser chip.

### Background Art

There has been known a high output power semiconductor laser chip that produces output power exceeding 10 W (see, for example, Fig. 9 of Patent Literature 1). Hereinafter, a semiconductor laser chip is also referred to simply as a chip. Such a chip achieves high output power by increasing the width of a current injection stripe that is an electrode for injecting a current into an active layer. Such a chip is referred to as a broad area type chip.

For mass production of such a chip, many chips are manufactured collectively with use of one wafer. Here, the chips are subjected to a manufacturing process in a state of being arranged in a matrix manner on a main surface of the wafer. Then, by cleaving the wafer in accordance with a boundary between adjacent chips, each of the chips is separated from other chips.

Note that the typical size of the chip is such that the length of the chip in the direction along a long side of the chip is several millimeters, and the length of the chip in the direction along a short side of the chip is several hundred micrometers.

### Citation List

### [Patent Literature]

[Patent Literature 1]
   Japanese Patent Application Publication Tokukaihei No. 9-36493
[Patent Literature 2]
   Japanese Patent Application Publication Tokukai No. 2019-057671

### Summary of Invention

### Technical Problem

Patent Literature 2 (paragraphs [0002] to [0006]) indicates that: a scribing scratch is formed on a wafer in order to form a trigger in cleavage of the wafer; and cracking may occur in a crystal from a starting point of cleavage when forming the scribing scratch. Furthermore, Patent Literature 2 (abstract and paragraph [0007]) indicates that, by virtue of provision of the grooves 44 (see Fig. 1 of Patent Literature 2), even if cracking has occurred in the rough surface region 58, the grooves 44 which are deeper than the active layer 32 stop the progression of the cracking, so that the influence on the active layer 32 can be prevented.

However, as a result of applying the technology of Patent Literature 2 to a broad area chip, the inventors of the present invention found that a failure may occur in the chip when a drive time is long (for example, several thousands of hours to several tens of thousands of hours).

An aspect of the present invention has been attained in view of the above-described problem, and an object thereof is to provide a chip in which a failure is less likely to occur than before even when a drive time is long.

### Solution to Problem

In order to solve the above problem, a chip in accordance with an aspect of the present invention is a broad area type chip including a substrate, an active layer which is laminated on the substrate, and a current injection stripe which injects a current into the active layer. The present chip employs a configuration in which: the chip has a pair of main surfaces, a reflection end surface, an emission end surface, and a pair of side surfaces; the pair of side surfaces include respective rough surfaces, which serve as starting points of cleavage, and respective cleavage surfaces; grooves extending along corresponding ones of the side surfaces are each formed in a region between a corresponding one of the rough surfaces and the current injection stripe when a main surface of the active layer is seen in a plan view from a direction normal to the main surface of the active layer; the grooves penetrate the active layer; and spacing between each of the grooves and the corresponding one of the side surfaces is not less than 25 µm.

In order to solve the above problem, a chip in accordance with an aspect of the present invention is a broad area type chip including a substrate, an active layer which is laminated on the substrate, a high-reflection film and a low-reflection film which constitute a resonator together with the active layer, and a current injection stripe which injects a current into the active layer. The present chip employs a configuration in which: the chip has a pair of main surfaces, a reflection end surface, an emission end surface, and a pair of side surfaces; the pair of side surfaces include respective rough surfaces, which serve as starting points of cleavage, and respective cleavage surfaces; stepped regions extending along corresponding ones of the side surfaces are each formed in a region between a corresponding one of the rough surfaces and the current injection stripe when a main surface of the active layer is seen in a plan view from a direction normal to the main surface of the active layer; the active layer is formed at different depths in the stepped regions and in regions other than the stepped regions; and spacing between each of the stepped regions and the corresponding one of the side surfaces is not less than 25 µm.

### Advantageous Effects of Invention

In a chip in accordance with an aspect of the present invention, a failure is less likely to occur than before even when a drive time is long.

### Brief Description of Drawings

Fig. 1 is a perspective view of a chip in accordance with an embodiment of the present invention.
(a) of Fig. 2 is a plan view of the chip illustrated in Fig. 1, and (b) of Fig. 2 is a cross-sectional view of the chip illustrated in Fig. 1.
Fig. 3 is a cross-sectional view of a variation of the chip illustrated in Fig. 1.
(a) to (f) of Fig. 4 are cross-sectional views illustrating a method for manufacturing the chip illustrated in Fig. 1.
Fig. 5 is a plan view illustrating a plurality of chips that have been manufactured by the manufacturing method illustrated in Fig. 4.
(a) to (c) of Fig. 6 are cross-sectional views illustrating a method for manufacturing the chip illustrated in Fig. 3.

### Description of Embodiments

### [Overview of chip]

A chip of a semiconductor laser (corresponding to a "semiconductor laser chip" in the claims) in accordance with an embodiment of the present invention is a chip known as a so-called broad area type. Examples of a use of the broad area type chip include excitation of YAG solid crystals and excitation of ytterbium-doped fibers. In a case where the YAG solid crystals are excited, the chip is designed such that laser light has a central wavelength of, for example, 808 nm. Further, in a case where the ytterbium-doped fibers are excited, the chip is designed such that laser light has a central wavelength of, for example, 976 nm. However, the central wavelength of laser light in the chip in accordance with an embodiment of the present invention is not limited to these and can be designed, as appropriate, in accordance with a use or the like.

### [Configuration of chip]

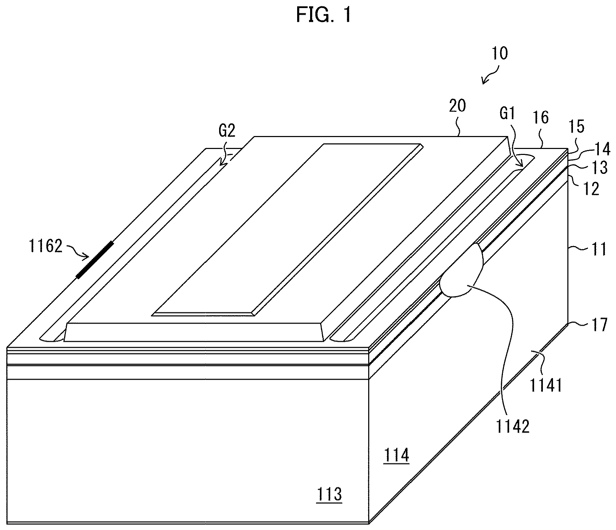

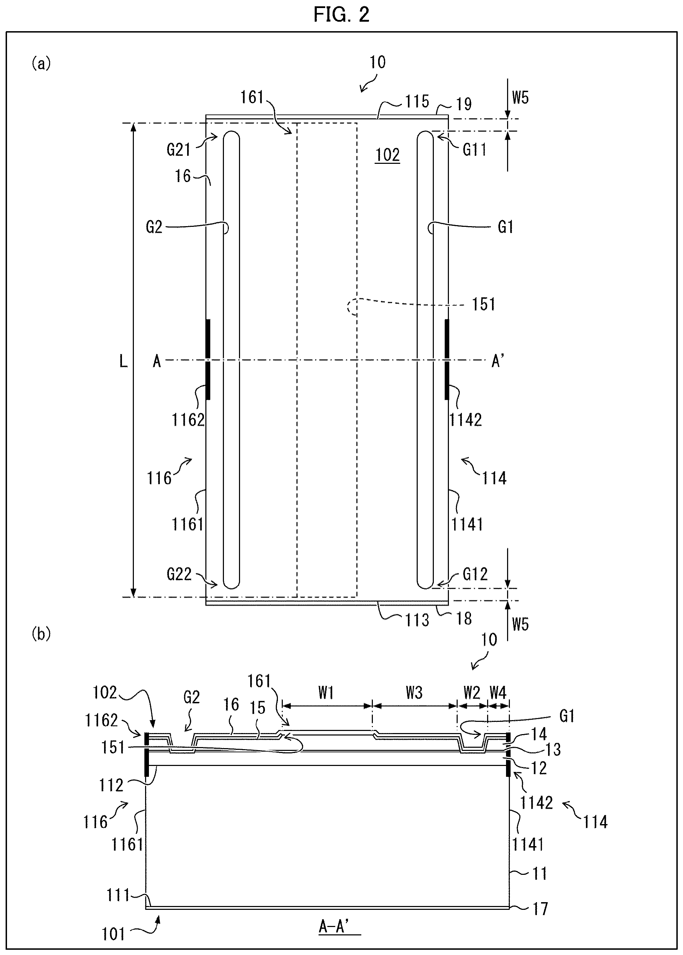

A chip 10 in accordance with an embodiment of the present invention will be described with reference to Figs. 1 and 2. Fig. 1 is a perspective view of the chip 10. (a) of Fig. 2 is a plan view of the chip 10, and (b) of Fig. 2 is a cross-sectional view of the chip 10. The plan view in (a) of Fig. 2 is a plan view obtained when a main surface of an active layer 13 (a main surface on a side farther from a substrate 11 among a pair of main surfaces of the active layer 13) in the chip 10 is seen in a plan view from a direction normal to the main surface of the active layer 13. The expression "plan view", as used hereinafter unless otherwise noted, means that the main surface of the active layer 13 is seen in a plan view from the direction normal to the main surface of the active layer 13. (b) of Fig. 2 is a cross-sectional view obtained in a cross section that is taken along a line A-A' illustrated in (a) of Fig. 2 and that is parallel to the direction normal to the main surface of the active layer 13.

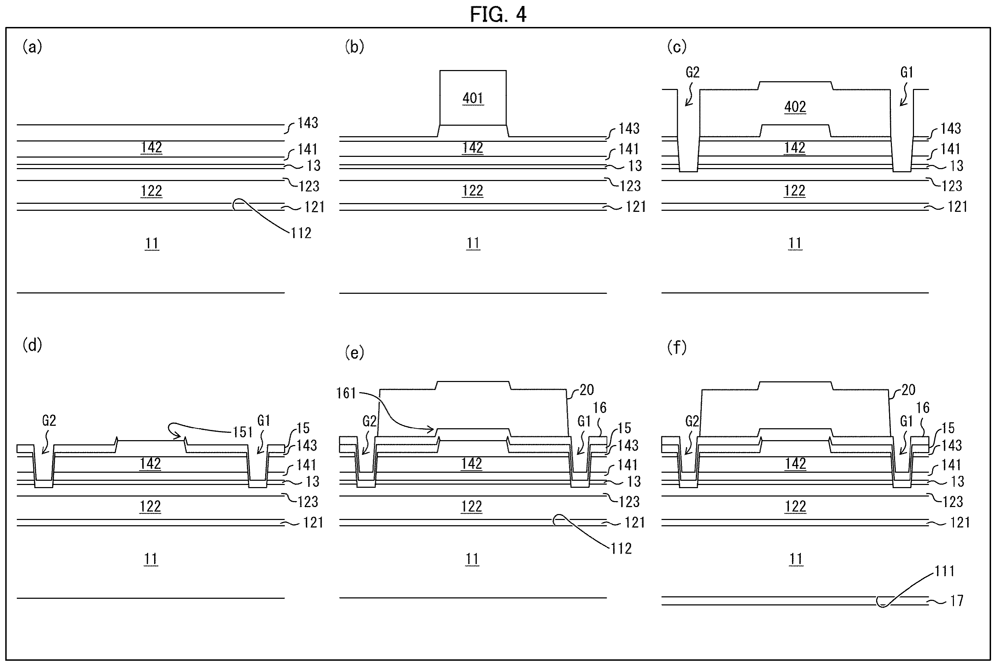

In the chip 10 illustrated in Figs. 1 and 2, the structures of an n-type layer 12 and a p-type layer 14 are simplified. More specific structures of the n-type layer 12 and the p-type layer 14 in the chip 10 will be described later with reference to Fig. 4. Further, in Fig. 2, a distortion suppression layer 20 is not illustrated.

As illustrated in Fig. 1, the chip 10 includes the substrate 11, the n-type layer 12, the active layer 13, the p-type layer 14, a dielectric layer 15, an electrode layer 16, and an electrode layer 17. In addition, the chip 10 further includes a distortion suppression layer 20 that is formed on an upper layer of the electrode layer 16. In addition, as illustrated in (a) of Fig. 2, the chip 10 further includes a low-reflection film 18 and a high-reflection film 19. However, the distortion suppression layer 20 may be omitted.

The chip 10 employs 4 mm as a length L (see (a) of Fig. 2) that is a total length of a current injection stripe 161 which will be described later. That is, a resonator length in the chip 10 is 4 mm. In addition, the chip 10 is a broad area type chip in which the current injection stripe 161, which will be described later, has a width W1 (see (b) of Fig. 2) of not less than 75 µm throughout all of sections thereof. The broad area type chip 10 can emit laser light having an output power of not less than 10 W. Note that a minimum value of the width W1 of the current injection stripe 161 is not limited to 75 µm, and, similarly, the output power of the chip 10 is not limited to 10 W. In addition, when mentioned in the present embodiment, the output power of the laser light in the chip 10 means a maximum output power of the chip 10. In the present embodiment, 4 mm and 220 µm are employed as the resonator length and the width W1, respectively, in a chip, and the output power of such a chip exceeds 20 W. In an aspect of the chip 10, sufficiently dissipating heat generated in the chip 10 during driving enables stable emission of laser light of 13 W per 100 µm in width W1. That is, in a case where 220 µm is employed as the width W1, selecting the length L within the range of approximately not less than 4 mm and not more than 6 mm enables stable emission of laser light having an output power of approximately not less than 25 W and not more than 28 W.

### <Substrate>

The substrate 11 is a plate-like member that is made of a single crystal of a semiconductor. The substrate 11 includes flat main surfaces 111 and 112 (see (b) of Fig. 2). In addition, the substrate 11 includes end surfaces 113 and 115 (see Fig. 1 and (a) of Fig. 2), which are a pair of end surfaces, and side surfaces 114 and 116 (see Fig. 1 and (a) of Fig. 2), which are a pair of side surfaces.

In the present embodiment, the end surface 113, the side surface 114, the end surface 115, and the side surface 116 are each obtained by cleaving a wafer that is made of a single crystal of a semiconductor. Here, the side surface 114 includes a cleavage surface 1141, which is formed by cleavage, and a rough surface 1142, which is caused by a scribing scratch that is a starting point of cleavage (see Figs. 1 and 2). Similarly, the side surface 116 includes a cleavage surface 1161, which is formed by cleavage, and a rough surface 1162, which is caused by a scribing scratch that is a starting point of cleavage (see Fig. 2). Note that, in Fig. 1, the rough surface 1142 is illustrated as a region. However, in (a) and (b) of Fig. 2, the rough surface 1142 is illustrated as a thick line segment. Similarly, in Fig. 1, (a) of Fig. 2, and (b) of Fig. 2, the rough surface 1162 is illustrated as a thick line segment.

In the present embodiment, GaAs is employed as a semiconductor of which the substrate 11 is composed. However, the semiconductor of which the substrate 11 is composed can be selected as appropriate.

The main surface 111, which is one main surface of the substrate 11 and is located on the lower side in Fig. 1 and (b) of Fig. 2, has the electrode layer 17 formed thereon. The electrode layer 17 is a metal thin film that is formed so as to cover the main surface 111. In the present embodiment, a three-layer film using Ni, Ge, and Au is employed as the electrode layer 17. However, the electrode layer 17 is not limited to this.

The main surface 112, which is another main surface of the substrate 11 and is located on the upper side in Fig. 1 and (b) of Fig. 2, has the n-type layer 12, the active layer 13, the p-type layer 14, the dielectric layer 15, and the electrode layer 16 stacked thereon in this order.

### <n-type layer>

The n-type layer 12 is composed of an n-type semiconductor. Examples of the n-type semiconductor of which the n-type layer 12 is composed include a GaAs-based semiconductor (e.g., AlGaAs). The n-type layer 12 may have a multilayer structure in which individual layers are composed of different types of n-type semiconductors. In this case, the layers of the n-type layer 12 may be configured so as to be layers having different functions, such as a layer that functions as a buffer layer, a layer that functions as a cladding layer, and a layer that functions as a guide layer.

### <Active layer>

The active layer 13 is composed of a semiconductor. Examples of the semiconductor of which the active layer 13 is composed include GaAs-based semiconductors (e.g., InGaAs).

### <p-type layer>

The p-type layer 14 is composed of a p-type semiconductor. Examples of the p-type semiconductor of which the p-type layer 14 is composed include a GaAs-based semiconductor (e.g., AlGaAs). The p-type layer 14 may have a multilayer structure in which individual layers are composed of different types of p-type semiconductors. In this case, the layers of the p-type layer 14 may be configured so as to be layers having different functions, such as a layer that functions as a guide layer, a layer that functions as a cladding layer, and a layer that functions as a contact layer.

### <Dielectric layer>

As illustrated in Fig. 1 and (b) of Fig. 2, the dielectric layer 15 is a thin film that is made of a dielectric and that is formed on, among a pair of main surfaces of the p-type layer 14, a main surface which is on the opposite side from the active layer 13 (a main surface located on the upper side in (b) of Fig. 2). The dielectric layer 15 is interposed between the electrode layer 16, which will be described later, and the active layer 13 so as to separate the electrode layer 16 and the active layer 13 from each other. The dielectric layer 15 is provided to limit a region via which a current can be injected into the active layer 13 from the electrode layer 16, which will be described later.

The dielectric layer 15 is composed of a dielectric. Examples of the dielectric of which the dielectric layer 15 is composed include SiO₂, SiN, Al₂O₃, and the like. The dielectric layer 15 has an opening 151 that is formed therein to limit a region via which a current injected from the electrode layer 16 is passed (see Fig. 2). In the present embodiment, when a main surface of the dielectric layer 15 (a main surface on a side farther from the substrate 11 among a pair of main surfaces of the dielectric layer 15) is seen in a plan view, the shape of the opening 151 is a rectangular shape (see (a) of Fig. 2). However, the shape of the opening 151 is not limited to a rectangular shape, provided that the opening 151 is shaped in a strip extending along one direction.

### <Electrode layer>

The electrode layer 16 is a metal thin film that is formed so as to cover, among the pair of main surfaces of the p-type layer 14, the main surface which is on the opposite side from the active layer 13. In the present embodiment, a two-layer film made of Ti and Au is employed as the electrode layer 16. However, the electrode layer 16 is not limited to this.

The electrode layer 16 and the electrode layer 17 function as a pair of electrodes that pass a current through the active layer 13. Hereinafter, when a main surface of the electrode layer 16 (among a pair of main surfaces of the electrode layer 16, a main surface which is on the opposite side from the dielectric layer 15) is seen in a plan view, a region via which a current is injected into the active layer 13 is referred to as the current injection stripe 161. That is, when the main surface of the electrode layer 16 is seen in a plan view, a region which overlaps the opening 151 and via which a current is injected into the active layer 13 is the current injection stripe 161. Thus, the current injection stripe 161 also includes a region of the p-type layer 14 which is interposed between the electrode layer 16 and the active layer 13 and which overlaps the opening 151.

### <Reflection film>

As illustrated in (a) of Fig. 2, in the chip 10, each of a pair of end surfaces constituting a resonator has a corresponding one of a pair of reflection films formed thereon. As illustrated in (a) of Fig. 2, among the pair of end surfaces that are a pair of end surfaces of the chip 10 and that constitute the resonator, one end surface (an end surface located on the lower side in (a) of Fig. 2) has a low-reflection film 18 formed thereon, and another end surface (an end surface located on the upper side in (a) of Fig. 2) has a high-reflection film 19 formed thereon. That is, spacing between the low-reflection film 18 and the high-reflection film 19 corresponds to the resonator length of the chip 10. The end surface on which the low-reflection film 18 is formed is an emission end surface, and the end surface on which the high-reflection film 19 is formed is a reflection end surface. The reflectivity of the low-reflection film 18 with respect to light of an oscillation wavelength is lower than the reflectivity of the high-reflection film with respect to the light. Note that, in Fig. 1, the low-reflection film 18 and the high-reflection film 19 are not illustrated.

The reflectivities of the high-reflection film 19 and the low-reflection film 18 can be each set as appropriate in accordance with the design of the chip 10. The configurations of the high-reflection film 19 and the low-reflection film 18 can be each selected as appropriate from among existing configurations. For example, as a low-reflection film 18 having a relatively low reflectivity, a monolayer film made of a material such as Al₂O₃, AlN, Si, SiO₂, or TiO₂ or a multilayer film made of these materials can be used. In addition, as a high-reflection film 19 having a relatively high reflectivity, a multilayer film obtained by repeatedly laminating a two-layer film made of these materials can be used.

Thus, among the pair of end surfaces of the chip 10, the end surface on which the high-reflection film 19 is formed functions as a reflection end surface that reflects light propagating through the resonator, and the end surface on which the low-reflection film 18 is formed functions as an emission end surface that emits laser light.

### <Distortion suppression layer>

The distortion suppression layer 20 is a metal film that is formed on, among the pair of main surfaces of the electrode layer 16, a main surface which is on the opposite side from the active layer 13 (a main surface located on the upper side in Fig. 1). The distortion suppression layer 20 covers, in the electrode layer 16, the current injection stripe 161 and a region surrounding the current injection stripe 161. Note that, in Fig. 2, the distortion suppression layer 20 is not illustrated.

In the present embodiment, a plating method is used to form the distortion suppression layer 20. However, the method for forming the distortion suppression layer 20 is not limited to the plating method. The method for forming the distortion suppression layer 20 can be selected as appropriate from among methods that are capable of forming a film of a desired thickness (e.g., 2 µm or 3 µm). Another method, which differs from the plating method, for forming the distortion suppression layer 20 includes, for example, a sputtering method.

For example, when the chip 10 is mounted on a submount with use of solder, the distortion suppression layer 20 is interposed between the electrode layer 16 and the solder layer and suppresses distortions that can occur in the chip.

### <Main surfaces, end surfaces, and side surfaces of chip>

As described above, the chip 10 includes: the substrate 11; the active layer 13 which is laminated on the main surface 112 of the substrate 11 via the n-type layer 12; the high-reflection film 19 and the low-reflection film 18 which constitute a resonator together with the active layer 13; and the current injection stripe 161 via which a current is injected into the active layer 13. The chip 10 has a pair of main surfaces 101 and 102.

In addition, the chip 10 has a pair of side surfaces that extend along a direction in which light propagates in the resonator. A main part of the pair of side surfaces is constituted by a pair of side surfaces 114 and 116 of the substrate 11. However, a pair of side surfaces of the n-type layer 12, a pair of side surfaces of the active layer 13, a pair of side surfaces of the p-type layer 14, a pair of side surfaces of the dielectric layer 15, and a pair of side surfaces of the electrode layer 16 are also included in the pair of side surfaces of the chip 10. Note that, in the pair of side surfaces, regions where the rough surfaces 1142 and 1162 are formed extend from the main surface 102 not only to the side surfaces of the electrode layer 16, the side surfaces of the dielectric layer 15, the side surfaces of the p-type layer 14, the side surfaces of the active layer 13, and the side surfaces of the n-type layer 12 but also to the pair of side surfaces 114 and 116 (see (b) of Fig. 2).

In addition, the chip 10 includes an end surface on which propagating light in the resonator is reflected (i.e., a reflection end surface) and an end surface from which a portion of the propagating light in the resonator is emitted (i.e., an emission end surface). A main part of the emission end surface and the reflection end surface is constituted by a pair of end surfaces 113 and 115 of the substrate 11. However, a pair of end surfaces of the n-type layer 12, a pair of end surfaces of the active layer 13, a pair of end surfaces of the p-type layer 14, a pair of end surfaces of the dielectric layer 15, and a pair of end surfaces of the electrode layer 16 are also included in the emission end surface and the reflection end surface.

### <Grooves>

The chip 10 has a groove G1 and a groove G2 formed therein (see (b) of Fig. 2).

When seen in a plan view, the groove G1 along the side surface 114 is formed in a region between the rough surface 1142 of the side surface 114 and the current injection stripe 161. Similarly, when seen in a plan view, the groove G2 along the side surface 116 is formed in a region between the rough surface 1162 of the side surface 116 and the current injection stripe 161.

The grooves G1 and G2 each have such a shape as to extend from the main surface 102 among the pair of main surfaces 101 and 102 of the chip 10 toward the insides of semiconductor layers that constitute the chip 10. As illustrated in (b) of Fig. 2, the grooves G1 and G2 penetrate through the p-type layer 14 and the active layer 13. Note that, in the chip 10, the main surface 101 is a main surface on the side of the main surface 111, and the main surface 102 is a main surface on the side of the main surface 112.

As illustrated in (a) and (b) of Fig. 2, the chip 10 has line symmetry with respect to a symmetrical axis that is an axis which passes through a central axis of the current injection stripe 161 and which is orthogonal to the main surface of the active layer 13. Thus, the groove G1 and the groove G2 are formed so as to be line-symmetric. The following will describe the configuration of a groove by taking, as an example, the groove G1 among the grooves G1 and G2. However, these configurations also apply to the groove G2, similarly to the groove G1.

As illustrated in (b) of Fig. 2, the width of the groove G1 is referred to as a width W2, spacing between the groove G1 and the current injection stripe 161 is referred to as a width W3, and spacing between the groove G1 and the side surface 114 is referred to as a width W4. In the chip 10, the width W4 is not less than 25 µm. In addition, in the chip 10, the width W3 is preferably not less than 30 µm.

Note that, in the present embodiment, 12 µm is employed as the width W2, 35 µm is employed as the width W3, and 43 µm is employed the width W4.

As illustrated in (a) of Fig. 2, when the main surface 102 of the chip 10 is seen in a plan view, the groove G1 is formed in a region between the emission end surface of the chip 10 and the reflection end surface of the chip 10. Both an end G11 and an end G12, which are both ends of the groove G1, are located between the emission end surface of the chip 10 and the reflection end surface of the chip 10. The end G11 and an end G21 are each separated by the width W5 from the reflection end surface 115. The end G12 and an end G22 are each separated by the width W5 from the emission end surface 113. That is, each of the ends G11 and G12 does not reach any of the emission end surface of the chip 10 and the reflection end surface of the chip 10.

### <Variation of chip>

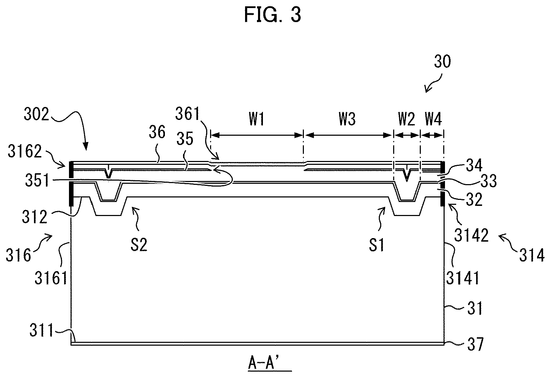

A chip 30, which is a variation of the chip 10, will be described with reference to Fig. 3. The chip 10 has a groove G1 and a groove G2 formed therein ((b) of Fig. 2). In contrast, the chip 30 has a stepped region S1 and a stepped region S2 formed therein. In the present variation, differences between the chip 10 and the chip 30 will be described.

In the chip 10, constituent elements are each given a reference sign where the first one digit is denoted as "1". On the other hand, in the chip 30, constituent elements corresponding to the constituent elements of the chip 10 are each given a reference sign where the first one digit is denoted as "3". For example, a substrate 31, an n-type layer 32, an active layer 33, and a p-type layer 34 which are included in the chip 30 correspond respectively to the substrate 11, the n-type layer 12, the active layer 13, and the p-type layer 14 which are included in the chip 10. Further, a side surface 314 and a side surface 316 of the chip 30 correspond respectively to the side surface 114 and the side surface 116 of the chip 10. Further, a cleavage surface 3141 and a rough surface 3142 of the chip 30 correspond respectively to the cleavage surface 1141 and the rough surface 1142 of the chip 10.

When seen in a plan view, two grooves are formed on one main surface of the substrate 31 in the chip 30 in correspondence with the region where the groove G1 and the groove G2 are formed in the chip 10. The n-type layer 32, the active layer 33, the p-type layer 34, and an electrode layer 36 are laminated on one main surface of the substrate 31 on which the grooves are formed. In addition, a block layer 35 is embedded in the p-type layer 34. The block layer 35 is a component corresponding to the dielectric layer 15 in the chip 10 and is provided to limit a region via which a current can be injected into the active layer 33 from the electrode layer 36. Like the dielectric layer 15, the block layer 35 is composed of a dielectric or a semiconductor that has electrical conductivity lower than that of a p-type semiconductor of which the p-type layer 34 is composed. Examples of a material of which the block layer 35 is composed include n-type GaAs.

The block layer 35 has an opening 351 that is formed therein to limit a region via which a current injected from the electrode layer 36 is passed (see Fig. 3). The opening 351 corresponds to the opening 151 illustrated in Fig. 2. When a main surface of the electrode layer 36 (among a pair of main surfaces of the electrode layer 36, a main surface which is on the opposite side from the block layer 35) is seen in a plan view, a region via which a current is injected into the active layer 33 is referred to as a current injection stripe 361. That is, when the main surface of the electrode layer 36 is seen in a plan view, a region which overlaps the opening 351 and via which a current is injected into the active layer 33 is the current injection stripe 361. Thus, the current injection stripe 361 also includes a region of the p-type layer 34 which is interposed between the electrode layer 16 and the active layer 13 and which overlaps the opening 351.

Thus, in the chip 30, since semiconductor layers, which are the n-type layer 32, the active layer 33, and the p-type layer 34, are laminated on the main surface 312 of the substrate 31 on which the grooves are formed, the stepped region S1 and the stepped region S2 are formed in the semiconductor layers (see Fig. 3). The active layer 33 is formed at different depths in each of the stepped regions S1 and S2 and in a region other than the stepped region S1 and other than the stepped region S2.

Note that, when seen in a plan view, the region where the stepped region S1 and the stepped region S2 are formed in the chip 30 is similar to the region where the groove G1 and the groove G2 are formed in the chip 10. That is, in the case of the stepped region S1 as an example, when seen in a plan view, the stepped region S1 is formed between the rough surface 3142 of the side surface 314 and the current injection stripe 361, and spacing W4 between the stepped region S1 and the side surface 314 is not less than 25 µm. Further, when seen in a plan view, the stepped region S1 is formed in a region between the reflection end surface and the emission end surface, and both ends of the step region S1 do not reach any of the reflection end surface and the emission end surface. Further, the width W3, which is spacing between the stepped region S1 and the current injection stripe 361, is not less than 30 µm.

Here, although the description has been given by taking the stepped region S1 as an example, the same applies to the stepped region S2.

### [Method for manufacturing chip]

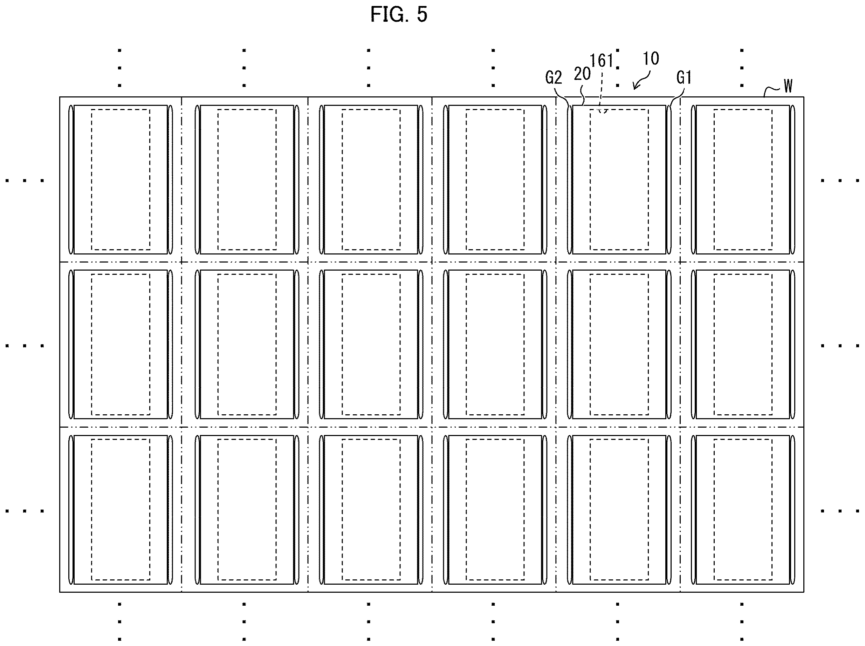

A method for manufacturing the chip 10 will be described with reference to Figs. 4 and 5. In the description of the present manufacturing method, a specific example of the chip 10 illustrated in Figs. 1 and 2 is used. (a) to (f) of Fig. 4 are cross-sectional views illustrating a method for manufacturing a specific example of the chip 10. The present manufacturing method includes a lamination step, a first etching step, a second etching step, a block layer formation step, a first electrode layer lamination step, a second electrode layer lamination step, and a cleavage step. Fig. 5 is a plan view illustrating a plurality of chips 10 that have been manufactured on a wafer W by the present manufacturing method.

(a) of Fig. 4 illustrates a state of the substrate 11 after the lamination step has been carried out. The lamination step is a step of laminating, on the main surface 112 of the substrate 11, a buffer layer 121, an n-type cladding layer 122, an n-type guide layer 123, an active layer 13, a p-type guide layer 141, a p-type cladding layer 142, and a p-type contact layer 143. In the present manufacturing method, an MOCVD method is used to laminate these layers.

The buffer layer 121, the n-type cladding layer 122, and the n-type guide layer 123 correspond to the n-type layer 12 illustrated in Figs. 1 and 2. Further, the p-type guide layer 141 and the p-type cladding layer 142, together with the p-type contact layer 143 described later, correspond to the p-type layer 14 illustrated in Figs. 1 and 2.

In the present manufacturing method, a plate-like member made of GaAs is used as the substrate 11. Further, GaAs is used as a material of which the buffer layer 121 is composed, Alₓ₁Ga_{1-x1A}s is used as a material of which the n-type cladding layer 122 is composed, Alₓ₂Ga₁₋ₓ₂As is used as a material of which the n-type guide layer 123 is composed, undoped InGaAs is used as a material of which the active layer 13 is composed, Alₓ₃Ga₁₋ₓ₃As is used as a material of which the p-type guide layer 141 is composed, Alₓ₄Ga₁₋ₓ₄As is used as a material of which the p-type cladding layer 142 is composed, and GaAs is used as a material of which the p-type contact layer 143 is composed. Here, x1>x2, and x4>x3. For the active layer 13, the composition and film thickness can be adjusted as appropriate so that a desired oscillation wavelength is obtained.

(b) of Fig. 4 illustrates a state of the substrate 11 after the first etching step has been carried out. In the first etching step, first, a photoresist is applied onto the p-type contact layer 143, and a photomask 401 corresponding to the current injection stripe 161 is formed using a photolithography method. After that, etching is carried out until the thickness of the p-type contact layer 143 is reduced to about half. By carrying out the first etching step, a ridge structure in which a region corresponding to the current injection stripe 161 is raised is obtained. In the first etching step, etching can be carried out with use of a mixed solution of tartaric acid and hydrogen peroxide or a mixed solution of sulfuric acid and hydrogen peroxide, or a chlorine-based dry etching can be used. In addition, in order to define a wet etching amount, an etching stop layer may be provided in an epitaxial layer.

(c) of Fig. 4 illustrates a state of the substrate 11 after the second etching step has been carried out. After the photomask 401 has been removed with use of an organic solvent, a photoresist is applied onto the p-type contact layer 143, and a photomask 402 having openings in regions corresponding to the groove G1 and the groove G2 is formed using a photolithography method. After that, etching is carried out until the groove G1 and the groove G2 each penetrating the active layer 13 and the p-type layer 14, which consists of the p-type guide layer 141, the p-type cladding layer 142, and the p-type contact layer 143, are formed. Note that the groove G1 and the groove G2 only need to penetrate the active layer 13 and the p-type layer 14. The depth to which the n-type layer 12, which consists of the buffer layer 121, the n-type cladding layer 122, and the n-type guide layer 123, is etched can be determined as appropriate. By carrying out the second etching step, the groove G1 and the groove G2 are formed.

(d) of Fig. 4 illustrates a state of the substrate 11 after the block layer formation step has been carried out. After the photomask 402 has been removed with use of an organic solvent, the dielectric layer 15 made of SiN is formed on the p-type contact layer 143 by a PCVD method. After that, in the same manner as in the first etching step and the second etching step, the opening 151 is formed in the dielectric layer 15 using a photolithography method and etching. After that, a photomask which has been formed on the dielectric layer 15 is removed with use of an organic solvent. By carrying out the block layer formation step, regions other than the opening 151 are all covered with the dielectric layer 15. Note that etching or removal with respect to a dielectric film constituting the dielectric layer 15 can be carried out, for example, using dry etching such as HF dry etching or F-based dry etching or using lift-off by a photoresist, according to etching characteristics of a dielectric of which the dielectric film is composed. For example, in a case where the dielectric is SiO₂ or SiN, dry etching can be used. On the other hand, in a case where a dielectric which cannot be removed by the above-described dry etching is used, the opening 151 can be provided by providing a mask made of a photoresist or a soluble material at a desired position before the dielectric layer 15 is formed, after that, providing a dielectric layer 15, and then dissolving the mask. Note that after the opening 151 has been formed in the block layer formation step, a surface treatment may be carried out with respect to the p-type contact layer 143 exposed from the opening 151. Examples of this surface treatment include a shallow etching using an inorganic acid.

(e) of Fig. 4 illustrates a state of the substrate 11 after the first electrode layer lamination step has been carried out. In the first electrode layer lamination step, an electrode layer 16 made of Ti, Pt, and Au is formed on the dielectric layer 15 on which the opening 151 is formed. Further, in the first electrode layer lamination step, a distortion suppression layer 20 made of Au may be formed on the electrode layer 16. The distortion suppression layer 20 can be formed using a plating method and a photolithography method.

(f) of Fig. 4 illustrates a state of the substrate 11 after the second electrode layer lamination step has been carried out. In the second electrode layer lamination step, thickness adjustment is made by grinding and polishing the main surface 111 of the substrate 11, after which the electrode layer 17 made of Ni, Ge, and Au is formed, and a heat treatment is carried out. A method for forming the electrode layer 17 can be selected from among existing film formation methods such as an electron beam vapor deposition method and a sputtering method. In addition, the temperature of the heat treatment can also be selected as appropriate, and examples thereof include 400°C. Note that, after the electrode layer 17 has been formed, a metallized layer (for example, Ti, Pt, and Au) in which a surface thereof is made of Au may be further provided. Providing the metallized layer makes it possible to enhance wire bondability at the time of mounting on a submount, an external electrode, or the like.

Fig. 5 is a plan view of a plurality of chips 10 that have been manufactured on a wafer W. A dot-dot-dash line illustrated in Fig. 5 indicates a boundary between adjacent chips 10. Each of the chips 10 illustrated in Fig. 5 corresponds to the chip 10 illustrated in (a) of Fig. 2. In Fig. 5, the groove G1, the groove G2, and the distortion suppression layer 20 are indicated by solid lines, and the current injection stripe 161 located below the distortion suppression layer 20 is indicated by a broken line. Note that Fig. 5 illustrates a total of 18 chips 10 that constitute three laser bars. Note that, in Fig. 5, a part of a substrate S (a region including the three laser bars) is illustrated in an enlarged view. More laser bars are provided on the main surface of the substrate S.

The chips 10 are subjected to splitting in chip form at the position of the dot-dot-dash line illustrated in Fig. 5. In the cleavage step, first, the wafer W is cleaved at the position of a dot-dot-dash line (in Fig. 5, a dot-dot-dash line extending in the left-right direction) corresponding to a boundary, of chips 10 which are adjacent to each other, between an emission end surface and a reflection end surface to obtain a laser bar with the emission end surface and 115 exposed. In doing so, a scribing scratch that is a starting point of the cleavage can be made in a region outside the region of the chips 10 arranged in the column direction. By this cleavage, a pair of end surfaces of the chip 10 are formed.

Next, the low-reflection film 18 is formed on a cleavage surface constituting the emission end surface of the chip 10, and the high-reflection film 19 is formed on a cleavage surface constituting the reflection end surface of the chip 10. The reflectivities of the low-reflection film 18 and the high-reflection film 19 can be freely selected in accordance with the design of the chip 10. Specifically, a low-reflection film 18 having a desired reflectivity can be realized by combining a monolayer film made of a material such as Al₂O₃, AlN, Si, SiO₂, or TiO₂ or a multilayer film which has about two layers made of these materials. The reflectivity of the low-reflection film 18 can be designed as appropriate, and typical examples thereof include a reflectivity of not less than 0.5% and not more than 5%. In addition, a high-reflection film 19 having a high reflectivity of near 100% can be realized by repeatedly laminating, a plurality of times, two-layer films made of materials selected from Al₂O₃, AlN, Si, SiO₂, TiO₂, and the like.

Next, the laser bar on which the low-reflection film 18 and the high-reflection film 19 have been formed is cleaved into individual chips 10 in chip form. A scribing scratch having a very short length is made on a portion that is on a boundary of the chips 10 which are adjacent to each other in the column direction (in Fig. 5, a dot-dot-dash line extending in the vertical direction) and that is located midway between the emission end surface and the reflection end surface, and the laser bar is cleaved into the chips 10. The portion on which this scribing scratch has been made corresponds to the rough surface 1142 and the rough surface 1162 of the chip 10 in chip form. By this cleavage, a pair of side surfaces of the chip 10 are formed.

Even when the length of the scribing scratch is approximately the same as the resonator length of the chip 10, cleavage is possible. However, since an order of magnitude larger number of chips 10 are split in comparison with the number of rows of laser bars, increasing the length of a scribing scratch becomes a factor responsible for cost increase from the aspects of both a tact time and a scribing tool life, and thus is not preferable.

Damage is left on the rough surface 1142 and the rough surface 1162 due to disorder of a crystalline structure and stress at the start of cleavage. This damage tends to become a factor of the occurrence of a slip in a case where the drive time is long. Therefore, it is preferable that, when the main surface 102 of the chip 10 is seen in a plan view, the groove G1 and the groove G2 be longer than the rough surface 1142 and the rough surface 1162 in the length direction of the resonator, and both ends of each of the rough surface 1142 and the rough surface 1162 be located further inward than the ends G11 and G12 and the ends G21 and G22, which are both ends of the groove G1 and both ends of the groove G2, respectively (see (a) of Fig. 2). This is also true for the chip 30. That is, it is preferable that, when the main surface 302 (see Fig. 3) of the chip 30 is seen in a plan view, in the length direction of the resonator, the stepped region S1 and the stepped region S2 be longer than the rough surface 3142 and the rough surface 3162 in the length direction of the resonator, and both ends of each of the rough surface 3142 and the rough surface 3162 be located further inward than both ends of each of the stepped region S1 and the stepped region S2, respectively. In addition, damage caused by a scribing scratch can reach deep (near the main surface 112) into the semiconductor layers (n-type layer 12, active layer 13, and p-type layer 14) that constitute the chip 10. Therefore, when the drive time is long, there is also a possibility that the slip progresses from a deep position in the semiconductor layers toward the active layer. Thus, the width W4 (see (b) of Fig. 2) is preferably not less than 25 µm in order to stop the progression of the slip from the deep position.

### [Second specific example of chip]

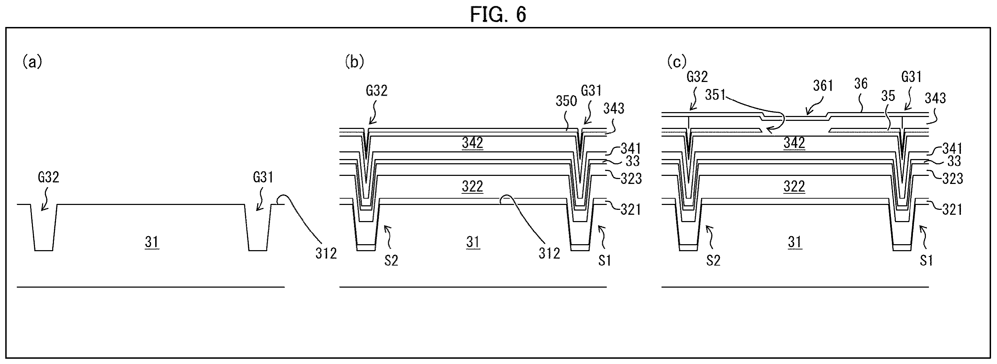

A second specific example of the chip 10 will be described with reference to Fig. 6. (a) to (c) of Fig. 6 are cross-sectional views illustrating a method for manufacturing a second specific example of the chip 10. The present specific example is a specific example of the chip 30 illustrated in Fig. 3.

In the present manufacturing method, before the lamination step is carried out, the groove G31 and the groove G32 are formed on the main surface 312 of the substrate 31. The groove G31 is formed in the region corresponding to the stepped region S1, and the groove G32 is formed in the region corresponding to the stepped region S2 (see (a) of Fig. 6). The groove G31 and the groove G32 are obtained using a photolithography method and etching in combination.

(b) of Fig. 6 illustrates a state of the substrate 31 after the lamination step has been carried out. The lamination step is a step of laminating, on the main surface 312 of the substrate 31, a buffer layer 321, an n-type cladding layer 322, an n-type guide layer 323, an active layer 33, a p-type guide layer 341, a p-type cladding layer 342, and a p-type contact layer 343, and a block layer 350. Since the buffer layer 321, the n-type cladding layer 322, the n-type guide layer 323, the active layer 33, the p-type guide layer 341, the p-type cladding layer 342, the p-type contact layer 343, and the block layer 35 correspond respectively to the buffer layer 121, the n-type cladding layer 122, the n-type guide layer 123, the active layer 13, the p-type guide layer 141, the p-type cladding layer 142, the p-type contact layer 143, and the dielectric layer 15 of the chip 10, a method for forming these layers is omitted.

As illustrated in (b) of Fig. 6, by carrying out the lamination step, the stepped region S1 and the stepped region S2 are formed.

After that, the block layer 35 is formed by forming the opening 351 in the block layer 350, and the electrode layer 36 is formed thereon to obtain the chip 30 (see (c) of Fig. 6). The block layer 35 corresponds to the dielectric layer 15 of the chip 10, the opening 351 corresponds to the opening 151 of the chip 10, and the electrode layer 36 corresponds to the electrode layer 16 of the chip 10.

Aspects of the present invention can also be expressed as follows:
A semiconductor laser chip (chip) in accordance with a first aspect of the present invention is a broad area type semiconductor laser chip including a substrate, an active layer which is laminated on the substrate, and a current injection stripe which injects a current into the active layer. The present semiconductor laser chip employs a configuration in which: the semiconductor laser chip has a pair of main surfaces, a reflection end surface, an emission end surface, and a pair of side surfaces; the pair of side surfaces include respective rough surfaces, which serve as starting points of cleavage, and respective cleavage surfaces; grooves extending along corresponding ones of the side surfaces are each formed in a region between a corresponding one of the rough surfaces and the current injection stripe when a main surface of the active layer is seen in a plan view from a direction normal to the main surface of the active layer; the grooves penetrate the active layer; and spacing between each of the grooves and the corresponding one of the side surfaces is not less than 25 µm.

The cause of a failure of a semiconductor laser chip that is likely to occur when a drive time is long is not limited to the cracking described in Patent Literature 2. One cause of this failure is also considered to be a slip that progresses from the starting point of cleavage (i.e., the rough surface described above). The slip that causes the failure is considered to be a dislocation loop that extends linearly on a sliding surface in parallel to the cleavage surface. It is considered that the slip is slowly moving toward a light-emitting portion (a region overlapping the current injection stripe in the active layer). Therefore, when the drive time is long, the failure occurs due to the slip reaching the light-emitting portion.

As a result of analysis on a semiconductor laser chip driven for a long period of time, the inventors of the present invention obtained the following findings regarding the slip.
(1) There are some semiconductor laser chips in which the slip does not occur even when the drive time is long. In these semiconductor laser chips, there occurs almost no failure caused by driving for a long period of time.
(2) The slip occurs at various depths in rough surfaces formed on corresponding ones of side surfaces of a semiconductor laser chip. Note that the rough surfaces extend from a surface layer of the semiconductor laser chip and reach the substrate.
(3) The slip tends to progress toward the surface layer of the semiconductor laser chip that is a free surface. Note, however, that the slip that has reached the active layer due to strong distortion of the active layer is easily trapped in the active layer as it is.
(4) Since the slip has the characteristics described in (3) above, the slip that has occurred on a side closer to the substrate side than the active layer progresses toward the surface layer of the semiconductor laser chip, but traverses the active layer midway. Such a slip is highly likely to progress the inside of the trapped active layer as it is, and is, in turn, highly likely to reach the light-emitting portion.

The inventors of the present invention found that there are many cases where even a slip in which a starting point thereof is a deep layer close to the substrate is trapped in the active layer during the progression over a distance of 25 µm and is observed as a dark slip line. According to the above configuration, the grooves are each provided at a corresponding one of positions such that spacing from a corresponding one of the side surfaces is not less than 25 µm. Thus, the slip trapped in the active layer can be released from the side surfaces of the grooves which are free surfaces. Thus, according to the above configuration, even when a slip has occurred as the drive time is long, further progression of the slip can be prevented in the grooves. Hence, it is possible to prevent the slip from extending between the grooves and the substrate and reaching the light-emitting portion. Therefore, in the present semiconductor laser chip, even when the drive time is long, a failure is less likely to occur than before.

Further, a semiconductor laser chip in accordance with a second aspect of the present invention employs, in addition to the above-described configuration of the semiconductor laser chip in accordance with the first aspect, a configuration in which: assuming that, in the resonator, an end surface on which the light is reflected and an end surface from which the light is emitted are the reflection end surface and the emission end surface, respectively, when the main surface of the active layer is seen in a plan view from the direction normal to the main surface of the active layer, the grooves are formed in a region between the reflection end surface and the emission end surface, and both ends of each of the grooves do not reach any of the reflection end surface and the emission end surface.

In the semiconductor laser chip, the reflection end surface and the emission end surface are each obtained by cleaving a wafer or a substrate. In a process of cleaving a wafer or a substrate, it is preferable that there is no discontinuous structure at a position corresponding to the reflection end surface and at a position corresponding to the emission end surface. In a case where there is a discontinuous structure at a position corresponding to the reflection end surface and at a position corresponding to the emission end surface, a displacement of a crystal plane occurs when cleavage progresses, and a level difference is likely to occur on the reflection end surface and on the emission end surface. Such a level difference is less likely to be a problem in a case where the level difference has occurred so as not to extend to an emission region from which laser light is emitted in the emission end surface, but is likely to be a cause of catastrophic optical damage (COD) failure of a semiconductor laser chip when the level difference has occurred so as to extend to the emission region. This is also true for the reflection end surface.

According to the above configuration, in the process of cleaving the wafer or the substrate, no discontinuous structure is provided at the position corresponding to the reflection end surface and at the position corresponding to the emission end surface. Thus, it is possible to decrease the possibility that the level difference may occur on the reflection end surface and on the emission end surface. Therefore, it is possible to improve the manufacturing yield of semiconductor laser chips.

In a broad area type semiconductor laser chip, the emission region and the reflection region each have a large width as the current injection stripe has a large width. Thus, the broad area type semiconductor laser chip has a higher possibility that, when the level difference has occurred, the level difference may extend to the emission region or the reflection region than a semiconductor laser chip that is not the broad area type semiconductor laser chip. Therefore, the above configuration is suitable for a broad area type semiconductor laser chip.

A semiconductor laser chip in accordance with a third aspect of the present invention employs, in addition to the above-described configuration of the semiconductor laser chip in accordance with the first aspect or the second aspect, a configuration in which spacing between each of the grooves and the current injection stripe is not less than 30 µm.

In order to reduce the size of a semiconductor laser chip, there is demand for decreasing the width of the semiconductor laser chip (spacing between a pair of side surfaces). Therefore, the spacing between each of the grooves and the current injection stripe is preferably small. On the other hand, the inventors found that, when the spacing between each of the grooves and the current injection stripe is too small, the refractive index distribution of the region where laser light propagates in the semiconductor laser chip is affected by the grooves. In this case, the shape of a beam spot of emitted laser light is deformed from a desired shape. In order to suppress the deformation that may occur in the beam spot, the spacing between each of the grooves and the current injection stripe is preferably not less than 30 µm.

A semiconductor laser chip in accordance with a fourth aspect of the present invention is a broad area type semiconductor laser chip including a substrate, an active layer which is laminated on the substrate, a high-reflection film and a low-reflection film which constitute a resonator together with the active layer, and a current injection stripe which injects a current into the active layer. The present semiconductor laser chip employs the configuration in which: the semiconductor laser chip has a pair of main surfaces, a reflection end surface, an emission end surface, and a pair of side surfaces; the pair of side surfaces include respective rough surfaces, which serve as starting points of cleavage, and respective cleavage surfaces; stepped regions extending along corresponding ones of the side surfaces are each formed in a region between a corresponding one of the respective rough surfaces of the side surfaces and the current injection stripe when a main surface of the active layer is seen in a plan view from a direction normal to the main surface of the active layer; the active layer is formed at different depths in the stepped regions and in regions other than the stepped regions; and spacing between each of the stepped regions and the corresponding one of the side surfaces is not less than 25 µm.

In the above-described semiconductor laser chip in accordance with the first aspect, forming the grooves penetrating the active layer and setting the spacing between each of the grooves and the corresponding one of the side surfaces to be not less than 25 µm suppresses intrusion of the slip into an internal region (that is, the region where laser light propagates) of the resonator. In the present semiconductor laser chip, using the stepped regions where the active layer is formed at different depths instead of the grooves suppresses intrusion of the slip into an internal region (that is, the region where laser light propagates) of the resonator. Therefore, the above configuration brings about the same effect as that of the semiconductor laser chip in accordance with the first aspect.

Note that the present semiconductor laser chip can be manufactured more easily than the semiconductor laser chip in accordance with the first aspect.

Further, a semiconductor laser chip in accordance with a fifth aspect of the present invention employs, in addition to the above-described configuration of the semiconductor laser chip in accordance with the fourth aspect, a configuration in which: assuming that, in the resonator, an end surface on which the light is reflected and an end surface from which the light is emitted are the reflection end surface and the emission end surface, respectively, when the main surface of the active layer is seen in a plan view from the direction normal to the main surface of the active layer, the stepped regions are formed in a region between the reflection end surface and the emission end surface, and both ends of each of the stepped regions do not reach any of the reflection end surface and the emission end surface.

The above configuration brings about the same effect as that of the semiconductor laser chip in accordance with the second aspect.

A semiconductor laser chip in accordance with a sixth aspect of the present invention employs, in addition to the above-described configuration of the semiconductor laser chip in accordance with the fourth aspect or the fifth aspect, a configuration in which spacing between each of the stepped regions and the current injection stripe is not less than 30 µm.

The above configuration brings about the same effect as that of the semiconductor laser chip in accordance with the third aspect.

Further, a semiconductor laser chip in accordance with a seventh aspect of the present invention employs, in addition to the above-described configuration of the semiconductor laser chip in accordance with any one aspect of the first aspect to the sixth aspect, a configuration in which the current injection stripe has a width of not less than 75 µm throughout all of sections thereof.

According to the above configuration, it is possible to provide a semiconductor laser chip that produces output power exceeding 10 W. Therefore, the present semiconductor laser chip can be suitably used for excitation of YAG solid crystals and excitation of ytterbium-doped fibers.

### [Supplemental notes]

The present invention is not limited to the embodiments, but can be altered by a skilled person in the art within the scope of the claims. The present invention also encompasses, in its technical scope, any embodiment derived by combining technical means disclosed in differing embodiments.

### Reference Signs List

10, 30: chip (semiconductor laser chip)
11, 31: substrate
12, 32: n-type layer
121, 321: buffer layer
122, 322: n-type cladding layer
123, 323: n-type guide layer
13, 33: active layer
14, 34: p-type layer
141,341: p-type guide layer
142, 342: p-type cladding layer
143, 343: p-type contact layer
15, 35: block layer
16, 17, 36, 7: electrode layer
161, 361: current injection stripe
18: low-reflection film
19: high-reflection film
20: distortion suppression layer
G1, G2: groove
S1, S2: stepped region

## Claims

1. A semiconductor laser chip of a broad area type comprising a substrate, an active layer which is laminated on the substrate, and a current injection stripe which injects a current into the active layer, wherein:
said semiconductor laser chip has a pair of main surfaces, a reflection end surface, an emission end surface, and a pair of side surfaces;
the pair of side surfaces include respective rough surfaces, which serve as starting points of cleavage, and respective cleavage surfaces;
grooves extending along corresponding ones of the side surfaces are each formed in a region between a corresponding one of the rough surfaces and the current injection stripe when a main surface of the active layer is seen in a plan view from a direction normal to the main surface of the active layer;
the grooves penetrate the active layer; and
spacing between each of the grooves and the corresponding one of the side surfaces is not less than 25 µm.

2. The semiconductor laser chip according to claim 1, wherein
when the main surface of the active layer is seen in a plan view from the direction normal to the main surface of the active layer, the grooves are formed in a region between the reflection end surface and the emission end surface, and both ends of each of the grooves do not reach any of the reflection end surface and the emission end surface.

3. The semiconductor laser chip according to claim 1 or 2, wherein
spacing between each of the grooves and the current injection stripe is not less than 30 µm.

4. A semiconductor laser chip of a broad area type comprising a substrate, an active layer which is laminated on the substrate, a high-reflection film and a low-reflection film which constitute a resonator together with the active layer, and a current injection stripe which injects a current into the active layer, wherein:
the semiconductor laser chip has a pair of main surfaces, a reflection end surface, an emission end surface, and a pair of side surfaces;
the pair of side surfaces include respective rough surfaces, which serve as starting points of cleavage, and respective cleavage surfaces;
stepped regions extending along corresponding ones of the side surfaces are each formed in a region between a corresponding one of the respective rough surfaces of the side surfaces and the current injection stripe when a main surface of the active layer is seen in a plan view from a direction normal to the main surface of the active layer;
the active layer is formed at different depths in the stepped regions and in regions other than the stepped regions; and
spacing between each of the stepped regions and the corresponding one of the side surfaces is not less than 25 µm.

5. The semiconductor laser chip according to claim 4, wherein
when the main surface of the active layer is seen in a plan view from the direction normal to the main surface of the active layer, the stepped regions are formed in a region between the reflection end surface and the emission end surface, and both ends of each of the stepped regions do not reach any of the reflection end surface and the emission end surface.

6. The semiconductor laser chip according to claim 4 or 5, wherein
spacing between each of the stepped regions and the current injection stripe is not less than 30 pm.

7. The semiconductor laser chip according to any one of claims 1 to 6, wherein
the current injection stripe has a width of not less than 75 µm throughout all of sections thereof.
